(19) **Europäisches Patentamt**
**European Patent Office**
**Office européen des brevets**

(11) **EP 4 653 891 A1**

(12) **EUROPEAN PATENT APPLICATION**

(43) Date of publication:
**26.11.2025 Bulletin 2025/48**

(21) Application number: **25161443.4**

(22) Date of filing: **04.03.2025**

(51) International Patent Classification (IPC):
**G01R 31/367** (2019.01)   **G01R 31/374** (2019.01)
**G01R 31/378** (2019.01)   **G01R 31/3835** (2019.01)
**G01R 31/388** (2019.01)   **G01R 31/392** (2019.01)
**G01R 31/396** (2019.01)   **H01M 10/48** (2006.01)

(52) Cooperative Patent Classification (CPC):
**G01R 31/392; G01R 31/367; G01R 31/374;
G01R 31/378; G01R 31/3835; G01R 31/388;
G01R 31/396; H01M 10/48**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **23.05.2024 KR 20240067303**

(71) Applicant: **SAMSUNG SDI CO., LTD.
Yongin-si, Gyeonggi-do 17084 (KR)**

(72) Inventors:
• **Kim, Minsoo**
  **17084 Yongin-Si Gyeonggi-do (KR)**
• **Ka, Bokhyun**
  **17084 Yongin-Si Gyeonggi-do (KR)**
• **Kwon, Moon-Seok**
  **17084 Yongin-Si Gyeonggi-do (KR)**

(74) Representative: **Gulde & Partner
Patent- und Rechtsanwaltskanzlei mbB
Berliner Freiheit 2
10785 Berlin (DE)**

(54) **METHOD OF ESTIMATING NEGATIVE ELECTRODE OF BATTERY AND BATTERY SYSTEM USING SAME**

(57)   A method of estimating negative electrode safety by at least one processor includes receiving, by the at least one processor, first charge data for at least one cell from a voltage sensor, receiving, by the at least one processor, second charge data for the at least one cell from the voltage sensor, and estimating, by the at least one processor, negative electrode safety for the at least one cell based on the first charge data and the second charge data, wherein the first charge data and the second charge data have different charge rates.

S1000

```
START
  │
  ▼
┌──────────────────────────────────────────────┐
│ RECEIVE FIRST CHARGE DATA FOR AT LEAST        │ ─S1010
│ ONE CELL FROM VOLTAGE SENSOR                  │
└──────────────────────────────────────────────┘
  │
  ▼
┌──────────────────────────────────────────────┐
│ RECEIVE SECOND CHARGE DATA FOR AT LEAST       │ ─S1020
│ ONE CELL FROM VOLTAGE SENSOR                  │
└──────────────────────────────────────────────┘
  │
  ▼
┌──────────────────────────────────────────────┐
│ RECEIVE THIRD CHARGE DATA ASSOCIATED          │ ─S1030
│ WITH BOL OF AT LEAST ONE CELL                 │
└──────────────────────────────────────────────┘
  │
  ▼
┌──────────────────────────────────────────────┐
│ ESTIMATE NEGATIVE ELECTRODE SAFETY FOR AT LEAST│ ─S1040
│ ONE CELL BASED ON FIRST, SECOND, AND THIRD CHARGE DATA│
└──────────────────────────────────────────────┘
  │
  ▼
┌──────────────────────────────────────────────┐
│ ADJUST CHARGE RATE UPPER LIMIT OF AT LEAST ONE CELL│ ─S1050
│ BASED ON ESTIMATED NEGATIVE ELECTRODE SAFETY  │
└──────────────────────────────────────────────┘
  │
  ▼
END
```

FIG. 10

EP 4 653 891 A1

**Description**

BACKGROUND

1. Field

Embodiments relate to a method of estimating the negative electrode safety of a battery based on charging data of the battery, and a battery system using the method.

2. Description of the Related Art

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

As batteries including secondary cells are becoming highly energized and requiring rapid charging, safety issues are becoming critical. In particular, lithium metal plating degradation occurring on the negative electrode of a battery is the most common cause of ignition and is associated with the degraded state of the negative electrode. **In** addition, understanding the state of anode degradation within a battery may be important for the optimal performance and reuse of the battery.

The above information disclosed in this Background section is for enhancement of understanding of the background of the present disclosure, and therefore, it may contain information that does not constitute related (or prior) art.

SUMMARY

The invention is defined by the appended claims. The description that follows is subjected to this limitation. Any disclosure lying outside the scope of said claims is only intended for illustrative as well as comparative purposes.

Embodiments include a method of estimating negative electrode safety by at least one processor, the method including receiving, by the at least one processor, first charge data for at least one cell from a voltage sensor, receiving, by the at least one processor, second charge data for the at least one cell from the voltage sensor, and estimating, by the at least one processor, negative electrode safety for the at least one cell based on the first charge data and the second charge data, wherein the first charge data and the second charge data have different charge rates.

The first charge data may include first charging voltage data based on a charge capacity obtained by charging the at least one cell at a first charge rate, and the second charge data may include second charging voltage data based on a charge capacity obtained by charging the at least one cell at a second charge rate.

The first charge rate may be slower than the second charge rate, and the second charge rate may be equal to or lower than a predetermined threshold.

The method may further include calculating first differential voltage data for the first charging voltage data, and calculating second differential voltage data for the second charging voltage data.

The first differential voltage data may include a 1_1st peak charge capacity and a 1_2nd peak charge capacity, the second differential voltage data may include a second peak charge capacity, the 1_1st peak charge capacity may be included in a first charge region, and the 1_2nd peak charge capacity and the second peak charge capacity may be included in a second charge region.

Estimating the negative electrode safety for the at least one cell includes estimating the negative electrode safety based on the 1_1st peak charge capacity, the 1_2nd peak charge capacity, and the second peak charge capacity.

Estimating the negative electrode safety for the at least one cell may include calculating an amount of peak change based on the 1_2nd peak charge capacity and the second peak charge capacity, and estimating the negative electrode safety based on the amount of peak change, the 1_1st peak charge capacity, and the 1_2nd peak charge capacity.

The at least one cell may be a lithium secondary cell, and the amount of peak change is associated with a degree of lithium plating on a negative electrode included in the at least one cell.

The first charge data and the second charge data may be generated by charging the at least one cell if a State of Charge (SoC) of the at least one cell is below an SoC threshold.

The method may further include receiving third charge data associated with a beginning of life (BoL) of the at least one cell, wherein estimating the negative electrode safety for the at least one cell includes estimating the negative electrode safety for the at least one cell based on first to third charge data, the first to third charge data including the first charge data, the second charge data and the third charge data.

Estimating the negative electrode safety for the at least one cell based on the first to third charge data may include calculating negative electrode health for the at least one cell based on the first charge data and the second charge data, calculating reference negative electrode health associated with the BoL of the at least one cell based on the third charge data, and estimating the negative electrode safety based on the negative electrode health and the reference negative electrode health.

The first charge data may include first charging voltage data based on a charge capacity obtained by charging the at least one cell at a first charge rate, the second charge data may include second charging voltage data based on a charge capacity obtained by charging the at least one cell at a second charge rate, and the third charge data may include third charging voltage data based on a charge capacity obtained by charging the at least one cell associated with the BoL, the method may further include calculating first differential voltage data for the first charging voltage data, calculating second differential voltage data for the second charging voltage data, and calculating third differential voltage data for the third charging voltage data, wherein the first differential voltage data may include a 1_1st peak charge capacity and a 1_2nd peak charge capacity, wherein the second differential voltage data includes a second peak charge capacity, wherein the third differential voltage data includes a 3_1th peak charge capacity and a 3_2th peak charge capacity, wherein the 1_1st peak charge capacity and the 3_1th peak charge capacity are included in a first charge region, and wherein the 1_2nd peak charge capacity, the second peak charge capacity, and the 3_2th peak charge capacity are included in a second charge region.

Estimating the negative electrode safety for the at least one cell based on the first to third charge data may include estimating the negative electrode safety for the at least one cell based on the 1_1st to 3_2th peak charge capacities, the 1_1st to 3_2th peak charge capacities including the 1_1st peak charge capacity, the 1_2nd peak charge capacity, the second peak charge capacity, the 3_1th peak charge capacity and the 3_2th peak charge capacity.

Charging the at least one cell may be performed until the at least one cell is fully charged, the first charge data includes a fully charged capacity associated with the first charge data, and estimating the negative electrode safety for the at least one cell based on the first to third charge data includes estimating the negative electrode safety for the at least one cell based on the fully charged capacity associated with the first charge data and the 1_1st to 3_2th peak charge capacities.

The negative electrode safety may be associated with a decrease in a capacity of a negative electrode and an increase in a resistance of the negative electrode.

The method may further include adjusting a charge rate upper limit of the at least one cell based on the estimated negative electrode safety.

Adjusting the charge rate upper limit of the at least one cell may include lowering the charge rate upper limit in response to determining that the negative electrode safety is below a safety threshold.

Embodiments include a battery system, the battery system including a voltage sensor configured to measure a voltage based on a charge capacity of at least one cell, and a controller configured to receive charge data generated by the voltage sensor and estimate negative electrode safety for the at least one cell based on the charge data, wherein the charge data includes first charge data for the at least one cell and second charge data for the at least one cell, and wherein the first charge data and the second charge data have different charge rates.

The charge data may further include third charge data associated with a beginning of life (BoL) of the at least one cell, and the controller may be configured to calculate negative electrode health for the at least one cell based on the first charge data and the second charge data, calculate reference negative electrode health associated with the BoL of the at least one cell based on the third charge data, and estimate the negative electrode safety based on the negative electrode health and the reference negative electrode health.

The controller may be further configured to adjust a charge rate upper limit of the at least one cell based on the estimated negative electrode safety.

These and other aspects and features of the present disclosure will be described in or will be apparent from the following description of embodiments of the present disclosure.

However, aspects and features of the present disclosure are not limited to those described above, and other aspects and features not mentioned will be clearly understood by a person skilled in the art from the detailed description, described below.

BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings, in which:

FIG. 1 illustrates a conceptual view showing a battery system 120 according to one or more embodiments of the present disclosure;
FIG. 2 illustrates a block diagram showing an internal configuration of a controller 200 according to one or more embodiments of the present disclosure;
FIG. 3 illustrates an example of charging voltage data of a negative electrode half cell according to one or more embodiments of the present disclosure;
FIG. 4 illustrates an example of differential voltage data of a negative electrode half cell according to one or more embodiments of the present disclosure;
FIG. 5 illustrates a graph showing an example relationship between a peak charge capacity and the length of a lithium plating risk zone for a negative electrode half cell according to one or more embodiments of the present disclosure;

FIG. 6 illustrates a graph showing an example of differential voltage data of a full cell according to one or more embodiments of the present disclosure;

FIG. 7 illustrates a graph showing an example of differential voltage data of a full cell according to one or more embodiments of the present disclosure;

FIG. 8 illustrates a graph showing an example of differential voltage data of a full cell according to one or more embodiments of the present disclosure;

FIG. 9 illustrates a graph showing an example of differential voltage data of a full cell according to one or more embodiments of the present disclosure;

FIG. 10 illustrates a flowchart showing an example of a method of estimating negative electrode safety or a negative electrode safety estimation method S1000 according to one or more embodiments of the present disclosure; and

FIG. 11 illustrates a flowchart showing an example of the step of estimating the negative electrode safety for the at least one cell according to one or more embodiments of the present disclosure.

DETAILED DESCRIPTION

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

Hereinafter, embodiments of the present disclosure will be described, in detail, with reference to the accompanying drawings. The terms or words used in the present specification and claims are not to be limitedly interpreted as general or dictionary meanings and should be interpreted as meanings and concepts that are consistent with the technical idea of the present disclosure on the basis of the principle that an inventor can be his/her own lexicographer to appropriately define concepts of terms to describe his/her invention in the best way.

The embodiments described in this specification and the configurations shown in the drawings are only some of the embodiments of the present disclosure and do not represent all of the technical spirit, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "includes," and/or "including," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all subranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

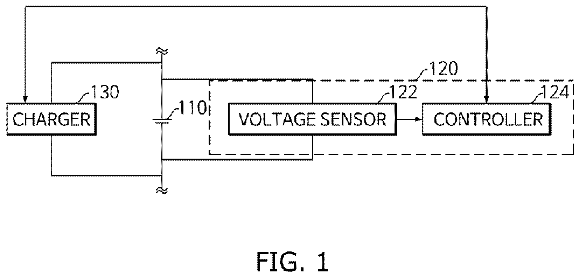

FIG. 1 illustrates a conceptual view showing a battery system 120 according to embodiments of the present disclosure. A battery cell 110 (hereinafter referred to as a "cell") may be charged by a charger 130. For example, the cell 110 may be disposed in an electronic device and may be charged by a charger included in the electronic device or by an external charger. Referring to FIG. 1, the cell 110 is shown only connected to the charger 130 and the battery system 120, but the present disclosure is not limited thereto. For example, the cell 110 may be electrically connected to an external configuration. The cell 110 may provide power to the external configuration while being charged, or may provide power to the external configuration after charging is complete. In another example, the cell 110 may be electrically connected to another external configuration after being disconnected from the battery system 120 and the charger 130.

The charger 130 may charge the cell 110 by varying the charge rate (C-rate). Herein, the charge rate may be the magnitude of charging current of the battery divided by the rated capacity of the battery. For example, the charger 130 may charge the cell 110 at a first charge rate. In another example, the charger 130 may charge the cell 110 at a second charge rate different from the first charge rate. For example, the first charge rate may be slower than the second charge rate.

In an embodiment, the second charge rate may be equal to or lower than a predetermined threshold. For example, the threshold may be 0.33 C or less, where C is a unit of charge rate that may refer to a charge rate at which a certain amount of time (e.g., 10 hours) is taken to fully charge the corresponding cell.

The battery system 120 may include a voltage sensor 122 and a controller 124. While the cell 110 is being charged by the charger 130, the voltage sensor 122 may generate charge data for the cell 110. The generated charge data may be transmitted to the controller 124.

The controller 124 may receive the generated charge data from the voltage sensor 122. The charge data may include charging voltage data based on a charge capacity obtained by charging the cell 110. The controller 124 may calculate differential voltage data based on the charging voltage data. The controller 124 may calculate a peak charge capacity based on the differential voltage data. In an embodiment, the charge data may include the differential voltage data, and the differential voltage data may include the peak charge capacity. In the following description, the controller 124 will be explained as calculating the differential voltage data based on the charging voltage data included in the charge data and calculating the peak charge capacity based on the differential voltage data, but is not limited thereto. For example, at least one processor included in the battery system 120 may calculate the differential voltage data and calculate the peak charge capacity.

In an embodiment, the charge data may be obtained by charging the cell 110 to a full state of charge. The charge data may include the charge capacity in the fully charged state of the cell 110, which is obtained by charging the cell 110 to a full state. In addition, the charge data may be obtained by charging the cell 110 the state of which is below an SoC threshold. For example, the SoC threshold may be a value included in the range of 0 to 40%. For example, the SoC threshold may be 25%. However, the SoC threshold is not limited thereto, and may be a predetermined value. Any suitable value may be used as the SoC threshold to obtain sufficient charge data.

In an embodiment, the cell 110 may be a battery cell that is in a middle-of-life (MoL) state. The cell 110 may be a battery the lifespan of which is reduced by repeated charging and discharging. For example, the state of health (SoH) of the cell 110 may be about 99% or less. However, this is not intended to be limiting, and the cell 110 may be a cell that has been charged and discharged one or more times immediately after manufacture.

In another embodiment, the cell 110 may be a battery cell that is in a beginning-of-life (BoL) state. The cell 110 may be a battery that has just been manufactured. For example, the SoH of the cell 110 may be about 100%. In another embodiment, the cell 110 may be a battery the voltage of which is first measured by the voltage sensor 122. That is, the cell 110 may be in a state before the lifespan there is reduced by the charger 130.

In an embodiment, first charge data may include first charging voltage data based on a charge capacity obtained by charging the cell 110, which is in the MoL state, at the first charge rate. Furthermore, second charge data may include second charging voltage data based on a charge capacity obtained by charging the cell 110, which is in the MoL state, at the second charge rate. In addition, third charge data may include third charging voltage data based on a charge capacity obtained by charging the cell 110 which is in the BoL state.

In an embodiment, the controller 124 may calculate negative electrode health based on the peak charge capacity. In addition, the controller 124 may calculate reference negative electrode health based on the peak charge capacity associated with the BoL. Based on the negative electrode health and the reference negative electrode health, the controller 124 may estimate the negative electrode safety of the cell 110.

The charger 130 and the controller 124 may communicate with each other. In addition, the controller 124 may adjust the charge rate of the charger 130. In an embodiment, the controller 124 may adjust the upper limit of the charge rate of the cell 110 based on the negative electrode safety. For example, in response to the controller 124 determining that the negative electrode safety is below a safety threshold, the upper limit of the charge rate of the cell 110 being charged by the charger 130 may be lowered.

Referring to FIG. 1, a single cell 110 is shown, but this is not intended to be limiting. For example, a plurality of cells may be charged by the charger 130, and the charge data may be generated by the voltage sensor 122. In an embodiment, the cells may be battery cells that are in the BoL state. In another embodiment, the cells may be battery cells in the MoL state that have been charged and discharged at least once in the BoL state.

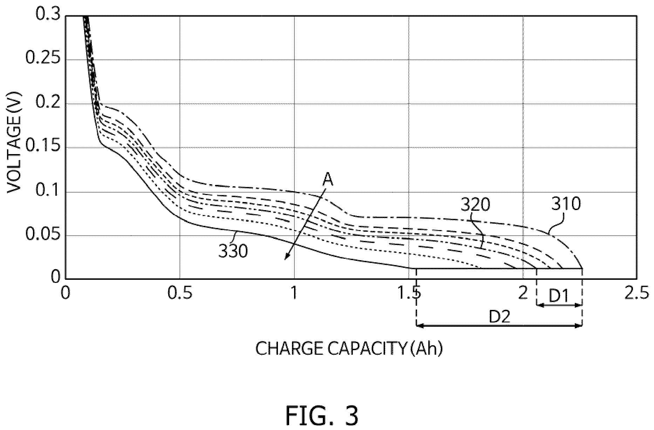

The lifespan of the cell 110 may decrease as the cell 110 is repeatedly charged and discharged. Specifically, the negative electrode included in the cell 110 may deteriorate as the cell 110 is repeatedly charged and discharged. The more the negative electrode of the cell is degraded, the greater the risk of lithium plating may be. As one skilled in the art will know, lithium plating is where metallic lithium deposits on the anode surface rather than being inserted into the anode material via intercalation. In addition, the faster the charge rate of the cell is, the greater the risk of lithium plating may be. A detailed description of this will be given with reference to FIGS. 3 to 5.

As described above, a method of estimating negative electrode safety according to the present disclosure may estimate the negative electrode safety of the cell 110 and adjust the charge rate of the cell 110 by comparing the negative electrode safety with a predetermined threshold. The adjusted (e.g., reduced) charge rate may reduce the risk of lithium plating in the cell 110. In addition, the adjusted charge rate may reduce the rate of degradation of the negative electrode that occurs as the cell 110 is repeatedly charged and discharged, and may slow the rate of decline in the lifespan of the cell 110.

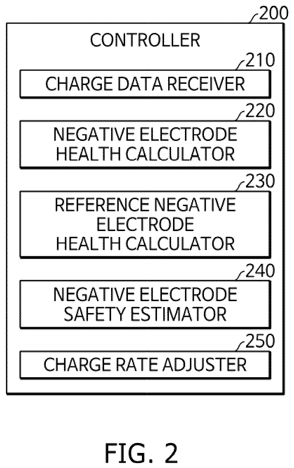

FIG. 2 illustrates a block diagram showing an internal configuration of a controller 200 according to embodiments of the present disclosure. The controller 200 may include a charge data receiver 210, a negative electrode health calculator 220, a reference negative electrode health calculator 230, a negative electrode safety estimator 240, and a charge rate adjuster 250. For example, the controller 200 may be the controller 124 included in the battery system 120 of FIG. 1.

The charge data receiver 210 may receive charge data from a voltage sensor (e.g., the voltage sensor 122 of FIG. 1). For example, the charge data receiver 210 may receive first charge data associated with a first charge rate and second charge data associated with a second charge rate from the voltage sensor. In addition, the charge data receiver 210 may receive third charge data associated with a BoL of at least one cell (e.g., the cell 110 of FIG. 1).

**In** an embodiment, the first charge data may include first charging voltage data based on a charge capacity obtained by charging the at least one cell at the first charge rate. The second charge data may include second charging voltage data based on a charge capacity obtained by charging the at least one cell at the second charge rate. The third charge data may include third charging voltage data based on a charge capacity obtained by charging the at least one cell in the BoL state.

In an embodiment, the negative electrode health calculator 220 may calculate differential voltage data for the charging voltage data included in the charge data. Specifically, the negative electrode health calculator 220 may derive the differential voltage data for the charging voltage data by differentiating the charging voltage data. For example, the negative electrode health calculator 220 may calculate first differential voltage data for the first charging voltage data and second differential voltage data for the second charging voltage data.

The negative electrode health calculator 220 may calculate a peak charge capacity based on the differential voltage data. For example, the negative electrode health calculator 220 may calculate a 1_1st peak charge capacity and a 1_2nd peak charge capacity based on the first differential voltage data. A detailed description of the peak charge capacity will be given with reference to FIGS. 3 to 7.

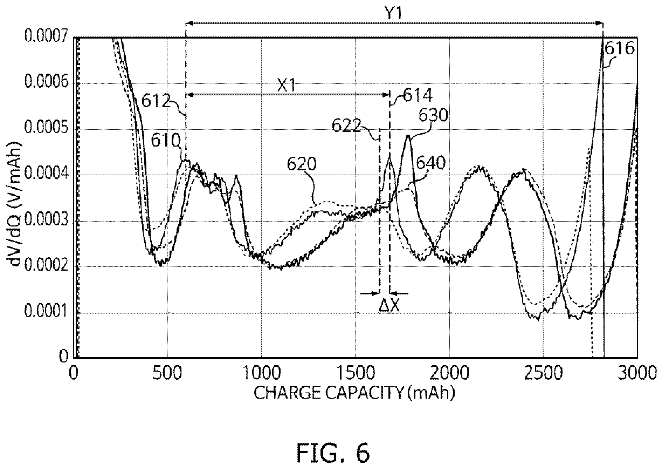

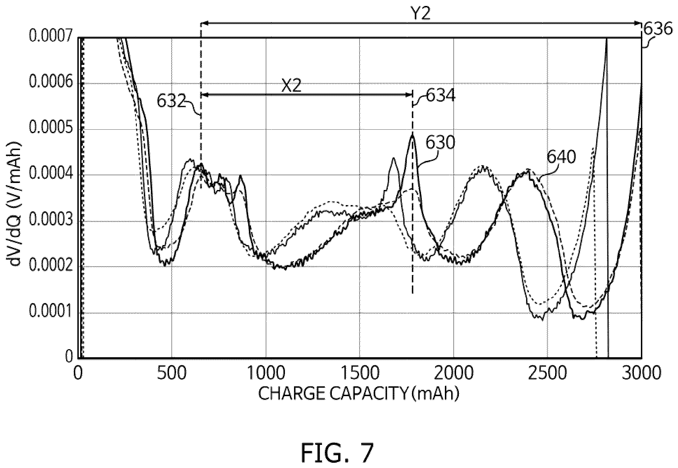

In an embodiment, the negative electrode health calculator 220 may calculate negative electrode health for the at least one cell based on the first charge data and the second charge data. For example, the negative electrode health may be calculated based on a peak charge capacity associated with the first charge data and a peak charge capacity associated with the second charge data. The process of calculating the negative electrode health based on the peak charge capacity will be described in detail with reference to FIGS. 6 and 7.

In an embodiment, similar to the negative electrode health calculator 220, the reference negative electrode health calculator 230 may calculate third differential voltage data for the third charge data associated with the BoL of the at least one cell. In addition, the reference negative electrode health calculator 230 may calculate a 3_1th peak charge capacity and a 3_2th peak charge capacity based on the third differential voltage data. The reference negative electrode health calculator 230 may calculate the reference negative electrode health based on the 3_1th peak charge capacity and the 3_2th peak charge capacity.

In an embodiment, in response to charging the at least one cell until the cell reaches a full state of charge, a voltage sensor (e.g., voltage sensor 122 of FIG. 1) may obtain a charge capacity in a fully charged state (hereinafter, referred to as a "fully charged capacity"). The charge data may include the fully charged capacity, and the charge data receiver 210 may receive the charge data including the fully charged capacity. The negative electrode health calculator 220 may calculate negative electrode health for the at least one cell based on the fully charged capacity of the at least one cell in the MoL state and the peak capacity associated with the MoL of the at least one cell. Similarly, the reference negative electrode health calculator 230 may calculate negative electrode health for the at least one cell based on the fully charged capacity of the at least one cell in the BoL state and the peak capacity associated with the BoL of the at least one cell.

In an embodiment, the negative electrode safety estimator 240 may estimate negative electrode safety based on the negative electrode health and the reference negative electrode health. Specifically, the negative electrode safety estimator 240 may estimate the negative electrode safety by comparing the negative electrode health with the reference negative electrode health. For example, the negative electrode safety may be equal to the negative electrode health divided by the reference negative electrode health. The specific process of calculating the negative electrode safety will be described in detail with reference to FIGS. 6 and 7.

In an embodiment, the charge rate adjuster 250 may adjust the charge rate of a charger that charges at least one cell based on the negative electrode safety. For example, the charge rate adjuster 250 may determine whether or not the estimated negative electrode safety is below a safety threshold. In response to determining that the estimated negative electrode safety is below the safety threshold, the charge rate adjuster 250 may lower the upper limit of the charge rate of the charger. For example, the safety threshold may be about 80%. In a case where the estimated negative electrode safety is less than 80%, the charge rate adjuster 250 may lower the upper limit of the charge rate (or the charge rate) such that the negative electrode stability is greater than or equal to 80%.

In an embodiment, controller 200 may include a memory and a processor. The memory may include any non-transitory computer-readable recording medium. According to an embodiment, the memory may include a non-transitory permanent mass storage device such as random access memory (RAM), read only memory (ROM), a disk drive, a solid state drive (SSD), flash memory, or the like. In another example, a non-transitory mass storage device, such as ROM, a SSD, flash memory, a disk drive, or the like, may be included in the controller 200 as a separate permanent storage device distinct from memory. In addition, the memory may store an operating system and at least one program code (e.g., code installed and executed on the controller 200 to, for example, estimate negative electrode safety).

The processor may be configured to process instructions from a computer program by performing basic arithmetic, logic, and input/output operations. The instructions may be provided to a charger (e.g., the charger 130 of FIG. 1), an external device, or another external system by a memory or a communication module. For example, the processor may calculate differential voltage data based on the charging voltage data. The processor may calculate the peak charge capacity based on the differential voltage data. The processor may estimate the negative electrode safety based on the charge data.

In addition, the controller 200 may further include a communication module. The communication module may provide configurations or functions for communicating with the charger, and may provide configurations or functions for the controller 200 to communicate with external devices, external systems, and the like. For example, control signals, commands, data, and the like provided under the control of the processor of the controller 200 may be transmitted to the charger, the external device, and/or the external system via the communication module.

FIG. 3 illustrates an example of charging voltage data of a negative electrode half cell according to embodiments of the present disclosure. Herein, the negative electrode half cell may be a coin half cell including graphite as a negative electrode. The negative electrode half cell may have a maximum charge capacity of 2.4 Ah. A negative electrode half cell prior to generating charging voltage data may be a half cell in a BoL state. For example, the negative electrode half cell may have been subjected to a formation process including two-time charge and discharge operations at a charge rate of 0.05C. Herein, the negative electrode half cell may refer to a battery cell that includes a negative electrode only, not a positive electrode.

The graph of FIG. 3 is an example of charging voltage data based on a charge capacity obtained by charging a negative electrode half cell. Specifically, a plurality of charging voltage data 310, 320 and 330 may be obtained by varying the charge rate. For example, the first charging voltage data 310 may be charging voltage data based on a charge capacity obtained by charging the negative electrode half cell at a charge rate of 0.1 C. The second charging voltage data 320 may be charging voltage data based on a charge capacity obtained by charging the negative electrode half cell at a charge rate between 0.1 and 1 C. Herein, the second charging voltage may be higher than the first charging voltage. The third charging voltage data 330 may be charging voltage data based on a charge capacity obtained by charging at a charge rate of 1 C. Referring to FIG. 3, the charge rate associated with the charging voltage data may be faster in a direction A.

The negative electrode half cell may be maximally charged to a predetermined voltage that may not be below 0 V. Referring to Figure 3, it may be seen that the negative electrode half cell is charged to the predetermined voltage. The negative electrode included in a full cell is configured to be charged to 0 V or less, but may not be charged to 0 V due to the characteristics of the half cell. In this context, the full cell may refer to a single battery cell containing positive and negative electrodes.

In the first charging voltage data 310, the fully charged capacity may be equal to or closest to the maximum charge capacity of the negative electrode half cell. For example, in the first charging voltage data 310, the fully charged capacity may be about 2.4 Ah. The fully charged capacity of the second charging voltage data 320 and the fully charged capacity of the third charging voltage data 330 may be less than the fully charged capacity of the first charging voltage data 310.

In this case, the greater the difference between the fully charged capacity of the nth charging voltage data (where n is a natural number greater than or equal to 2) and the fully charged capacity of the first charging voltage data 310, the greater the risk of lithium plating on the negative electrode of a cell charged at a charge rate associated with the nth charging voltage data may be. For example, the difference D2 between the fully charged capacity of the third charging voltage data and the fully charged capacity of the first charging voltage data may be greater than the difference D1 between the fully charged capacity of the second charging voltage data and the fully charged capacity of the first charging voltage data. In this case, a cell charged at a charge rate associated with the third charging voltage data may be at a greater risk of lithium plating than a cell charged at a charge rate associated with the second charging voltage data. Herein, the difference between the fully charged capacity of the nth charging voltage data and the fully charged capacity of the first charging voltage data 310 may be referred to as the length of a lithium plating risk zone.

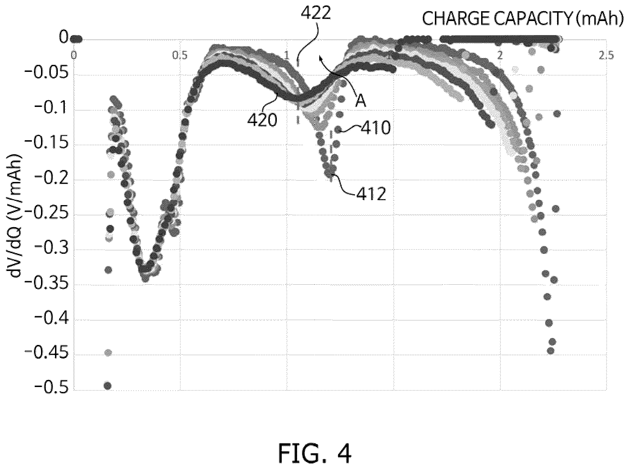

FIG. 4 illustrates an example of differential voltage data of a negative electrode half cell according to embodiments of the present disclosure. Specifically, FIG. 4 may illustrate differential voltage data for the charging voltage data 310 to 330 shown in FIG. 3.

Referring to FIG. 4, the charge rate associated with the differential voltage data may increase in the direction A. For example, the charge rate of the negative electrode half cell corresponding to the first differential voltage data 410 may be slower than the charge rate of the negative electrode half cell corresponding to the second differential voltage data 420. For example, the charge rate of the negative electrode half cell corresponding to the first differential voltage data 410 may be 0.1 C. In addition, the charge rate of the negative electrode half cell corresponding to the second differential voltage data 420 may be 1 C.

Each of the differential voltage data may include a plurality of peaks. For example, Tth differential voltage data included in the differential voltage data may include a $T\_1$th peak and a $T\_2$th peak (e.g., where T is a natural number greater than or equal to 1). In this case, the $T\_1$th peak may include a $T\_1$th peak charge capacity, which is the charge capacity corresponding to the $T\_1$th peak. The $T\_2$th peak may include a $T\_2$th peak charge capacity, which is the charge capacity corresponding to the $T\_2$th peak.

Referring to a region in FIG. 4 where the charge capacity is less than 0.5 Ah, a peak may be formed for each of the differential voltage data. Referring to FIG. 4, the downwardly convex portion of the graph may correspond to the peak. However, this is not intended to be limiting, and in a case where the differential voltage data is expressed in absolute values, an upwardly convex portion of a graph may correspond to a peak. These peaks may be associated with the T_1th peak for each of the differential voltage data. Referring to a region between 1.0 Ah and 1.5 Ah of a charge capacity in FIG. 4, a peak may be formed for each of the differential voltage data. The peaks may be associated with the T_2th peak for each of the differential voltage data.

In an embodiment, the T_1th peak charge capacity may be included in a first charge region. The T_2th peak charge capacity may be included in a second charge region. The first charge region may be determined to include a charge capacity at which the SoC of the cell to be measured is 25%. For example, the first charge region may be a region where the SoC of the cell to be measured is between 15% and 35%. The second charge region may be determined to include a charge capacity at which the SoC of the cell to be measured is 50%. For example, the second charge region may be a region where the SoC of the cell to be measured is 40% to 60%.

In an embodiment, in a case where a plurality of peaks are formed in a single charge region for a single piece of differential voltage data, the peak corresponding to the peak charge capacity closest to the reference value of this charge region may be selected. For example, the reference value of the first charge region may be 25% of the cell to be measured. The reference value of the second charge region may be 50% of the cell to be measured.

Referring to FIG. 4, the first differential voltage data 410 may include a 1_1st peak (not shown) and a 1_2nd peak 412. The 1_2nd peak 412 may include 1_2nd peak charge capacity. The second differential voltage data 420 may include a 2_1 peak (not shown) and a 2_2th peak 422. The 2_2th peak 422 may include 2_2th peak charge capacity. In an example, the charge rate corresponding to the first differential voltage data 410 may be slower than the charge rate corresponding to the second differential voltage data 420. In this case, the 1_2nd peak charge capacity may be higher than the 2_2nd peak charge capacity. As such, the T_2th peak appearing in the differential voltage data may be shifted to the left as the charge rate increases. Herein, the peak shift may be defined as the 1_2nd peak charge capacity minus the n_2 peak charge capacity, where n is a natural number greater than or equal to 2.

The phenomenon of the T_2th peak shift with increasing charge rate may occur in MoL batteries. On the other hand, the phenomenon of T_2th peak shift with increasing charge rate may not occur in BoL batteries. In another example, the degree of T_2th peak shift in BoL batteries may be relatively less than that in MoL batteries. As a result, the T_2th peak shift seen in BoL batteries may be ignored.

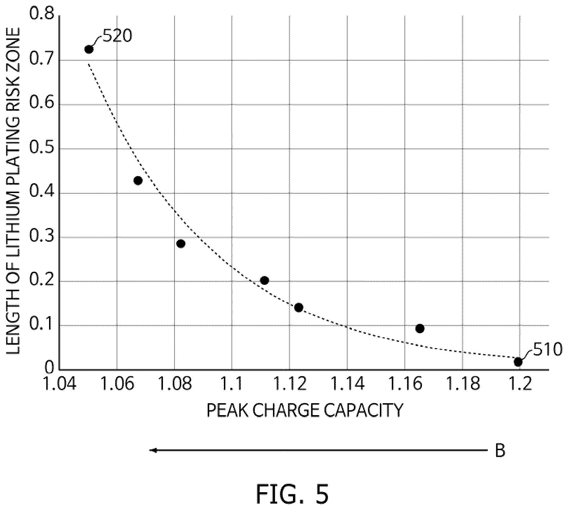

FIG. 5 illustrates a graph showing an example relationship between a peak charge capacity and the length of a lithium plating risk zone for a negative electrode half cell according to embodiments of the present disclosure. The Y-axis of FIG. 5 may represent the length of the lithium plating risk zone for the charging voltage data of the negative electrode half cell described with reference to FIG. 3. The x-axis of FIG. 5 may represent the T_2th peak charge capacity for the differential voltage data of the negative electrode half cell described with reference to FIG. 4.

The first data 510 may be associated with the first charging voltage data 310 of FIG. 3 while being associated with the first differential voltage data 410 of FIG. 4. That is, the first differential voltage data 410 of FIG. 4 may be differential with respect to the first charging voltage data 310 of FIG. 3. The length of the lithium plating risk zone included in the first data 510 may be about 0 Ah, and the peak charge capacity included in the first data 510 may be about 1.2 Ah.

The second data 520 may be associated with the second charging voltage data 320 of FIG. 3 while being associated with the second differential voltage data 420 of FIG. 4. That is, the second differential voltage data 420 of FIG. 4 may be differential with respect to the second charging voltage data 320 of FIG. 3. The length of the lithium plating risk zone included in the second data 520 may be about 0.73 Ah, and the peak charge capacity included in the second data 520 may be about 1.05 Ah.

The data shown in FIG. 5 may be correlated with the charge rate. For example, the charge rate of each of the data may increase in a direction B. For example, the charge rate corresponding to the first data 510 may be slower than the charge rate corresponding to the second data 520.

Referring to FIG. 5, the peak charge capacity may decrease with increasing charge rate. As the peak charge capacity becomes lower, the length of the lithium plating risk zone may increase. In other words, the greater the peak shift described with reference to FIG. 4, the greater the risk of lithium plating may be. In addition, the risk of lithium plating may increase with increasing charge rate. Therefore, it may be desirable to adjust the charge rate of the cell to prevent lithium plating.

FIG. 6 illustrates a graph showing an example of differential voltage data of a full cell according to an embodiment of the present disclosure. FIG. 7 illustrates a graph showing an example of differential voltage data of a full cell according to an embodiment of the present disclosure. The graphs in FIGS. 6 and 7 may show the differential voltage data in absolute values.

The full cells may be battery cells each of which includes a positive electrode and a negative electrode. The positive electrode of the full cell may include NCA with 88% Ni, and the negative electrode of the full cell may include graphite and silicon. In FIGS. 6 and 7, the MoL may refer to a state immediately after manufacture, wherein 60 charge-discharge cycles of charging at a charge rate of 3 C and discharging at a discharge rate of 0.5 C have been performed. The maximum capacity of the full cell may be about 3 Ah.

First charging voltage data may include a charge capacity obtained by charging the full cell in the MoL state at a first charge rate (e.g., 0.05 C). First differential voltage data 610 may be a differential of the first charging voltage data. The first charging voltage data may include the fully charged capacity 616 of the full cell in the MoL.

Second charging voltage data may include a charge capacity obtained by charging the full cell in the MoL state at the second charge rate (e.g., 0.2 C). Second differential voltage data 620 may be a differential of the second charging voltage data.

Third charging voltage data may include a charge capacity obtained by charging the full cell in the BoL state at the first charge rate (e.g., 0.05 C). Third differential voltage data 630 may be a differential of the third charging voltage data. The third charging voltage data may include the fully charged capacity 636.

Fourth charging voltage data may include a charge capacity obtained by charging the full cell in the BoL state at the second charge rate (e.g., 0.2 C). Fourth differential voltage data 640 may be a differential of the fourth charging voltage data.

The first differential voltage data 610 may include a 1_1st peak and a 1_2nd peak. The first differential voltage data 610 may include a 1_1st peak charge capacity 612 for the 1_1st peak and a 1_2nd peak charge capacity 614 for the 1_2nd peak.

The second differential voltage data 620 may include a 2_1th peak and a 2_2th peak. The second differential voltage data 620 may include a 2_1 peak charge capacity for the 2_1 peak and a 2_2th peak charge capacity for the 2_2th peak.

The 1_1st peak and the 2_1th peak may be included in the first charge region. For example, the first charge region may be a region where the SoC of the cell to be measured is 20% to 30%. **In** addition, the 1_2nd peak and the 2_2th peak may be included in a second charge region. For example, the second charge region may be a region where the SoC of the cell to be measured is 45% to 55%.

The negative electrode health may be associated with a full cell in the MoL state. The negative electrode health may be calculated based on the 1_1st peak charge capacity 612, the 1_2nd peak charge capacity 614, the 2_2th peak charge capacity 622, and the fully charged capacity 616 of the full cell in the MoL state. Specifically, the negative electrode health may be calculated using Equation 1 below.

[Equation 1]

$$\text{anode health} = (\beta X1 - Y1) - \alpha \Delta X$$

In Equation 1 above, X1 may be the 1_2nd peak charge capacity 614 minus the 1_1st peak charge capacity 612. Y1 may be the fully charged capacity 616 of the full cell in the MoL state minus the 1_1st peak charge capacity 612. ΔX may be an amount of peak change that is the 1_2nd peak charge capacity minus the 2_2th peak charge capacity. Further, α may be a first proportionality constant that varies with the difference between the first charge rate and the second charge rate and β may be a second proportionality constant that varies with the material of the negative electrode. For example, in a case where the negative electrode includes graphite, β may be about 3.

In the negative electrode health, (βX1 - Y1) may be associated with an increase in the resistance of the negative electrode. **In** the negative electrode health, αΔX may be associated with a decrease in the capacity of the negative electrode. The decrease in the capacity of the negative electrode may be related to the extent to which lithium is plated, and αΔX may be related to the extent to which lithium is plated. That is, the lower the calculated negative electrode health, the greater the resistance of the negative electrode of the cell may be determined to have increased. In addition, the lower the calculated negative electrode health, the lower the capacity of the negative electrode of the cell may be determined to have decreased.

The third differential voltage data 630 may include a 3_1th peak and a 3_2th peak. The third differential voltage data 630 may include a 3_1th peak charge capacity 632 for the 3_1th peak and a 3_2th peak charge capacity 634 for the 3_2th peak.

The fourth differential voltage data 640 may include a 4_1th peak and a 4_2th peak. The fourth differential voltage data 640 may include a 4_1th peak charge capacity for the 4_1th peak and a 4_2th peak charge capacity for the 4_2th peak.

The 3_1th peak and the 4_1th peak may be included in the first charge region. In addition, the 3_2th peak and the 4_2th peak may be included in the second charge region. The 3_1th peak charge capacity may be the same as or similar to the 4_1th peak charge capacity. Similarly, the 3_2th peak charge capacity and the 4_2th peak charge capacity may be the same or similar. That is, the full cell in the BoL state may not experience any negative electrode degradation and thus no peak shift and/or no peak change. In another example, the full cell in the BoL state may have a very small peak shift and/or peak change even in a case where negative electrode degradation occurs. As a result, the peak shift and/or peak change for the full cell in the BoL state may be negligible.

Reference negative electrode health may be associated with a full cell in the BoL state. The reference negative electrode health may be calculated based on the 3_1th peak charge capacity 632, the 3_2th peak charge capacity 634, and the fully charged capacity 636 of the full cell in the BoL state. Specifically, the reference negative electrode health may be calculated using Equation 2 below.

[Equation 2]

$$\text{reference anode health} = \beta X2 - Y2$$

In Equation 2 above, X2 may be the 3_2th peak charge capacity 634 minus the 3_1th peak charge capacity 632. Y2 may be the fully charged capacity 636 of the full cell in the BoL state minus the 3_1th peak charge capacity 632.

The negative electrode safety may be calculated based on the negative electrode health and the reference negative electrode health. Specifically, the negative electrode safety may be calculated by comparing the negative electrode health and the reference negative electrode health. For example, negative electrode safety may be negative electrode health/reference negative electrode health multiplied with 100: negative electrode safety (%) = (negative electrode health)/(reference negative electrode health) X 100. **In** other words, the negative electrode safety may be calculated as shown in Equation 3 below.

[Equation 3]

$$\text{anode safety} = \frac{(\beta X1 - Y1) - \alpha \Delta X}{(\beta X2 - Y2)}$$

The negative electrode safety may be a value calculated by comparing the reference negative electrode health associated with the battery cell in the BoL state with the negative electrode health associated with the battery cell in the MoL state. The negative electrode safety may represent both the degree of increase in the resistance of the negative electrode of the battery cell to be estimated (e.g., the battery cell in the MoL state) and the degree of decrease in the capacity of the negative electrode. **In** other words, the greater the negative electrode safety, the safer the battery cell having this negative electrode safety may be considered.

As described above, the negative electrode safety may be a reference for determining the extent to which the capacity of the negative electrode has decreased and the extent to which the resistance of the negative electrode has increased. Because the degradation of a negative electrode decreases the capacity of the negative electrode and increases the resistance of the negative electrode, the negative electrode safety may better indicate the degree of degradation of the negative electrode. In addition, the use of the method of estimating negative electrode safety according to the present disclosure may be facilitated by the fact that the conditions of the negative electrode may be determined using data on the full cell being charged.

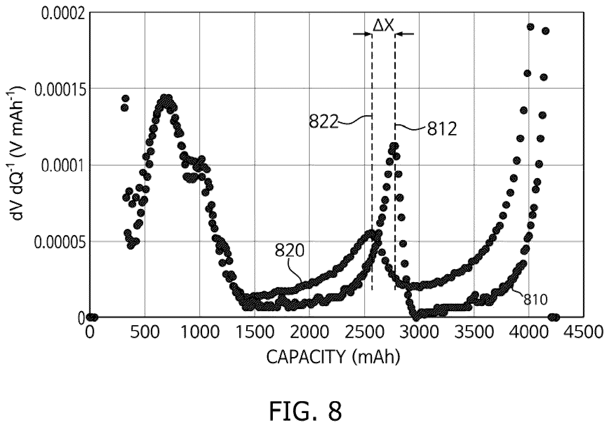

FIG. 8 illustrates a graph showing an example of differential voltage data of a full cell according to another embodiment of the present disclosure. The full cell according to another embodiment may be identical to the full cell described with reference to FIG. 7, except for the inclusion of LFP as a positive electrode. Different materials may result in different maximum capacities, etc. of the full cell.

First charging voltage data may include a charge capacity obtained by charging the full cell in the MoL state at a first charge rate (e.g., 0.05 C). First differential voltage data 810 may be a differential of the first charging voltage data. Second charging voltage data may include a charge capacity obtained by charging the full cell in the MoL state at a second charge rate (e.g., 0.33 C). Second differential voltage data 820 may be a differential of the second charging voltage data.

The first differential voltage data 810 may include a first peak. The first differential voltage data 810 may include a first peak charge capacity 812 for the first peak. The second differential voltage data 820 may include a second peak. The second differential voltage data 820 may include a second peak charge capacity 822 for the second peak. Herein, the first peak and the second peak may be included in a charge region (e.g., a region where the SoC of the cell to be measured is 45% to 55%).

Referring to FIG. 8, the faster the charge rate, the lower the peak charge capacity may be. Specifically, the first peak charge capacity 812 may be higher than the second peak charge capacity 822. That is, an amount of peak change ΔX may occur as the charge rate varies, and the peak may shift as the charge rate becomes faster.

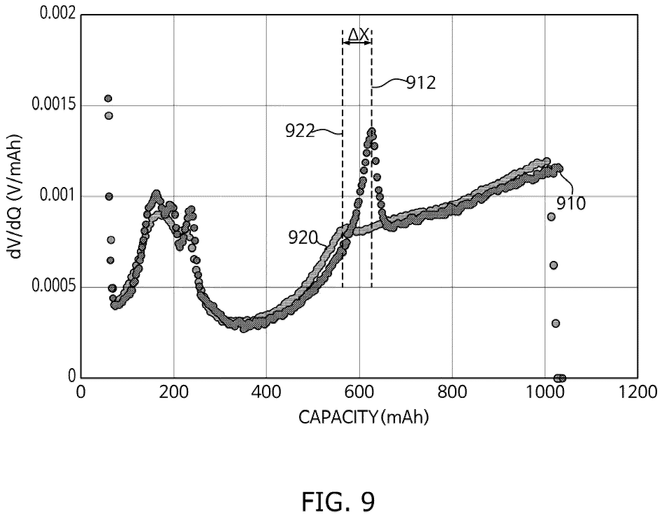

FIG. 9 illustrates a graph showing an example of differential voltage data of a full cell according to another embodiment of the present disclosure. The full cell according to another embodiment may be identical to the full cell described with reference to FIG. 7, except for the inclusion of NCM622 as a positive electrode. Different materials may result in different maximum capacities, etc. of the full cell.

First charging voltage data may include a charge capacity obtained by charging the full cell in the MoL state at a first charge rate (e.g., 0.05 C). First differential voltage data 910 may be a differential of the first charging voltage data. Second charging voltage data may include a charge capacity obtained by charging the full cell in the MoL state at a second charge rate (e.g., 0.33 C). Second differential voltage data 920 may be a differential of the second charging voltage data.

The first differential voltage data 910 may include a first peak. The first differential voltage data 910 may include a first peak charge capacity 912 for the first peak. The second differential voltage data 920 may include a second peak. The second differential voltage data 920 may include a second peak charge capacity 922 for the second peak. Herein, the first peak and the second peak may be included in a charge region (e.g., a region where the SoC of the cell to be measured is 45% to 55%).

Referring to FIG. 9, the faster the charge rate, the lower the peak charge capacity may be. Specifically, the first peak charge capacity 912 may be higher than the second peak charge capacity 922. That is, an amount of peak change $\Delta X$ may occur as the charge rate varies, and the peak may shift as the charge rate becomes faster.

As described with reference to FIGS. 8 and 9, a peak change may occur in a case where the material of the positive electrode varies. The method of estimating negative electrode safety according to the present disclosure may be applied to battery cells regardless of the material of the positive electrode. Accordingly, the method of estimating negative electrode safety according to the present disclosure may have greater versatility for secondary batteries.

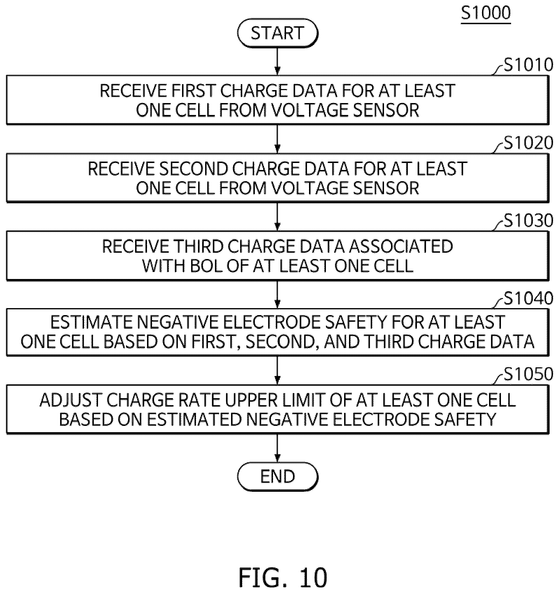

FIG. 10 illustrates a flowchart showing an example of a method of estimating negative electrode safety or a negative electrode safety estimation method S1000 according to embodiments of the present disclosure. The negative electrode safety estimation method S1000 may be executed by a battery system. Herein, the battery system may include a voltage sensor and a controller. The controller may include at least one processor. The voltage sensor may measure a voltage based on the charge capacity of at least one cell.

First, the negative electrode safety estimation method S1000 may be started by receiving first charge data for the at least one cell from the voltage sensor (S1010).

In an embodiment, the controller may receive second charge data for the at least one cell from the voltage sensor (S1020). Herein, the first charge data and the second charge data may be generated by charging the at least one cell in a state in which the state of charge (SoC) of the at least one cell is below an SoC threshold.

In an embodiment, the first charge data may include first charging voltage data based on a charge capacity obtained by charging the at least one cell at a first charge rate, and the second charge data may include second charging voltage data based on a charge capacity obtained by charging the at least one cell at a second charge rate.

In an embodiment, the controller may estimate negative electrode safety for the at least one cell based on the first charge data and the second charge data. Herein, the negative electrode safety may be associated with a decrease in the capacity of the negative electrode and an increase in the resistance of the negative electrode. For example, the first charge data and the second charge data may have different charge rates (C-rate). In addition, the first charge rate may be slower than the second charge rate, and the second charge rate may be equal to or lower than a predetermined threshold.

In an embodiment, the controller may calculate first differential voltage data for the first charging voltage data. In addition, the controller may calculate second differential voltage data for the second charging voltage data.

In an embodiment, the first differential voltage data may include a 1_1st peak charge capacity and a 1_2nd peak charge capacity, and the second differential voltage data may include a second peak charge capacity. Herein, the 1_1st peak charge capacity may be included in the first charge region, and the 1_2nd peak charge capacity and the second peak charge capacity may be included in the second charge region.

In an embodiment, the controller may estimate the negative electrode safety based on the 1_1st peak charge capacity, the 1_2nd peak charge capacity, and the second peak charge capacity. For example, the controller may calculate an amount of peak change based on the 1_2nd peak charge capacity and the second peak charge capacity. In addition, the controller may estimate the negative electrode safety based on the amount of peak change, the 1_1st peak charge capacity, and the 1_2nd peak charge capacity.

In an embodiment, the at least one cell is a lithium secondary cell, and the amount of peak change may be associated with the extent to which lithium has been plated on the negative electrode included in the at least one cell.

In an embodiment, the controller may receive third charge data associated with the BoL of the at least one cell (S 1030).

In an embodiment, the controller may estimate the negative electrode safety for the at least one cell based on the first to third charge data (S1040).

In an embodiment, the controller may adjust the charge rate upper limit of the at least one cell based on the estimated negative electrode safety (S1050). Specifically, the controller may lower the charge rate upper limit in response to determining that the negative electrode safety is below a safety threshold.

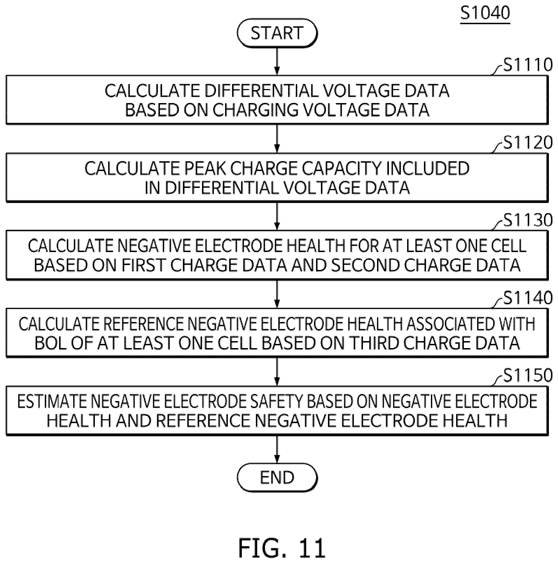

FIG. 11 illustrates a flowchart showing an example of the step S1040 of estimating the negative electrode safety for the at least one cell according to embodiments of the present disclosure. Step S1040 may be started by calculating the differential voltage data based on the charging voltage data (S 1110). In an embodiment, the first charge data may include the first charging voltage data based on the charge capacity obtained by charging the at least one cell at the first charge rate, the second charge data may include the second charging voltage data based on the charge capacity obtained by charging the at least one cell at the second charge rate, and the third charge data may include the third charging voltage data based on the charge capacity obtained by charging the at least one cell in the BoL state. In addition, the controller may calculate the first differential voltage data for the first charging voltage data. The controller may calculate the second differential voltage data for the second charging voltage data. The controller may calculate the third differential voltage data for the third charging voltage data.

In an embodiment, the controller may calculate the peak charge capacity included in the differential voltage data (S1120). For example, the first differential voltage data may include the 1_1st peak charge capacity

and the 1_2nd peak charge capacity, the second differential voltage data may include the second peak charge capacity, and the third differential voltage data may include the 3_1th peak charge capacity and the 3_2th peak charge capacity. The 1_1st peak charge capacity and the 3_1th peak charge capacity may be included in the first charge region, and the 1_2nd peak charge capacity, the second peak charge capacity, and the 3_2th peak charge capacity may be included in the second charge region. The controller may calculate the 1_1st to 3_2th peak charge capacities.

**In** an embodiment, the controller may calculate the negative electrode health for the at least one cell based on the first charge data and the second charge data (S1130).

In an embodiment, the controller may calculate reference negative electrode health associated with the BoL of the at least one cell based on the third charge data (S1140).

In an embodiment, the controller may estimate the negative electrode safety based on the negative electrode health and the reference negative electrode health (S1150). For example, the controller may estimate the negative electrode safety for the at least one cell based on the 1_1st to 3_2th peak charge capacities.

In addition, the first charge data may include a fully charged capacity associated with the first charge data. The controller may estimate the negative electrode safety for the at least one cell based on the fully charged capacity associated with the first charge data and the 1_1st to 3_2th peak charge capacities.

According to various embodiments of the present disclosure, the adjusted charging rate may reduce the risk of lithium plating in a battery cell. In addition, the rate of anode degradation that occurs as the battery cell is repeatedly charged and discharged may be lowered, and the rate of decline in the lifespan of the battery cell may be lowered.

According to various embodiments of the present disclosure, negative electrode safety may be a reference for determining the extent to which a negative electrode capacity has decreased as well as the extent to which a negative electrode resistance has increased. Because the degradation of the negative electrode decreases the negative electrode capacity and increases the negative electrode resistance, the negative electrode safety may be more indicative of the degree of degradation of the negative electrode.

According to various embodiments of the present disclosure, considering that the state of the negative electrode may be determined using data about a full cell being charged, it may be easy to use the method of estimating negative electrode safety according to the present disclosure.

According to various embodiments of the present disclosure, the method of estimating negative electrode safety may be applied to a battery cell regardless of the material of the anode. Accordingly, the method of estimating negative electrode safety may have great versatility for secondary batteries.

The flowcharts of FIGS. 10 and 11 and the above description are merely illustrative of the present disclosure, but the scope of the present disclosure is not limited to the flowcharts of FIGS. 10 and 11 and the above description. For example, one or more of the steps in the flowcharts and the above description may be added/altered/deleted, the order of one or more of the steps may be changed, and one or more of the steps may be performed substantially at the same time.

It is desirable to non-destructively diagnose the internal condition of a battery to determine the state of anode degradation. Charge and discharge voltage data may be used to diagnose the internal condition of a battery, but it is difficult to determine the negative electrode degradation separately from the positive electrode degradation from the charge and discharge voltage data of the battery. It may also be difficult to use the charge and discharge voltage data to determine the negative electrode degradation including the effects of not only a decreased negative electrode capacity but also an increased negative electrode resistance.

**Claims**

1. A method of estimating negative electrode safety by at least one processor, the method including:

   receiving, by the at least one processor, first charge data for at least one cell (110) from a voltage sensor (122);
   receiving, by the at least one processor, second charge data for the at least one cell (110) from the voltage sensor (122); and
   estimating, by the at least one processor, negative electrode safety for the at least one cell (110) based on the first charge data and the second charge data,
   wherein the first charge data and the second charge data have different charge rates.

2. The method as claimed in claim 1, wherein the first charge data includes first charging voltage data (310, 320, 330) based on a charge capacity obtained by charging the at least one cell (110) at a first charge rate, and
   the second charge data includes second charging voltage data (310, 320, 330) based on a charge capacity obtained by charging the at least one cell (110) at a second charge rate.

3. The method as claimed in claim 2, wherein the first charge rate is slower than the second charge rate, and the second charge rate is equal to or lower than a predetermined threshold.

**4.** The method as claimed in claim 2, further including:

 calculating first differential voltage data (410, 420) for the first charging voltage data (310, 320, 330); and
calculating second differential voltage data (410, 420) for the second charging voltage data (310, 320, 330).

**5.** The method as claimed in claim 4, wherein:

 the first differential voltage data (610) includes a 1_1st peak charge capacity (612) and a 1_2nd peak charge capacity (614),
the second differential voltage (620) data includes a second peak charge capacity (622),
the 1_1st peak charge capacity (612) is included in a first charge region, and
the 1_2nd peak charge capacity (612) and the second peak charge capacity (622) are included in a second charge region.

**6.** The method as claimed in claim 5, wherein estimating the negative electrode safety for the at least one cell (110) includes estimating the negative electrode safety based on the 1_1st peak charge capacity (612) , the 1_2nd peak charge capacity (614) , and the second peak charge capacity (622).

**7.** The method as claimed in claim 5, wherein estimating the negative electrode safety for the at least one cell (110) includes:

 calculating an amount of peak change based on the 1_2nd peak charge capacity (614) and the second peak charge capacity (622); and
estimating the negative electrode safety based on the amount of peak change, the 1_1st peak charge capacity (612), and the 1_2nd peak charge capacity (614).

**8.** The method as claimed in any one of the preceding claims, further including receiving third charge data associated with a beginning of life (BoL) of the at least one cell (110),
wherein estimating the negative electrode safety for the at least one cell (110) includes estimating the negative electrode safety for the at least one cell (110) based on first to third charge data, the first to third charge data including the first charge data, the second charge data and the third charge data.

**9.** The method as claimed in claim 8, wherein estimating the negative electrode safety for the at least one cell (110) based on the first to third charge data includes:

 calculating negative electrode health for the at least one cell (110) based on the first charge data and the second charge data;
calculating reference negative electrode health associated with the BoL of the at least one cell (110) based on the third charge data; and
estimating the negative electrode safety based on the negative electrode health and the reference negative electrode health.

**10.** The method as claimed in claim 8, wherein:

 the first charge data (310, 320, 330) includes first charging voltage data based on a charge capacity obtained by charging the at least one cell (110) at a first charge rate,
the second charge data (310, 320, 330) includes second charging voltage data based on a charge capacity obtained by charging the at least one cell (110) at a second charge rate, and
the third charge data (310, 320, 330) includes third charging voltage data based on a charge capacity obtained by charging the at least one cell (110) associated with the BoL,
the method further including:

 calculating first differential voltage data (610) for the first charging voltage data; (310, 320, 330)
calculating second differential voltage data (620) for the second charging voltage data (310, 320, 330); and
calculating third differential voltage data (630, 640) for the third charging voltage data (310, 320, 330),

wherein:

 the first differential voltage data (610) includes a 1_1st peak charge capacity (612) and a 1_2nd peak charge capacity (614),
the second differential voltage data (620) includes a second peak charge capacity (622),
the third differential voltage data (630, 640) includes a 3_1th peak charge capacity (632) and a 3_2th peak charge capacity (634),
the 1_1st peak charge capacity (612) and the 3_1th peak charge capacity (632) are included in a first charge region, and
the 1_2nd peak charge capacity (614), the second peak charge capacity (622), and the 3_2th peak charge capacity (634) are included in a second charge region.

**11.** The method as claimed in any one of the preceding claims, further including adjusting a charge rate upper limit of the at least one cell (110) based on the estimated negative electrode safety.

12. The method as claimed in claim 11, wherein adjusting the charge rate upper limit of the at least one cell (110) includes lowering the charge rate upper limit in response to determining that the negative electrode safety is below a safety threshold.

13. A battery system, including:

a voltage sensor (122) configured to measure a voltage based on a charge capacity of at least one cell (110); and
a controller (124) configured to receive charge data generated by the voltage sensor (122) and estimate negative electrode safety for the at least one cell (110) based on the charge data, wherein the charge data includes first charge data for the at least one cell (110) and second charge data for the at least one cell (110), and wherein the first charge data and the second charge data have different charge rates.

14. The battery system as claimed in claim 13, wherein:

the charge data further includes third charge data associated with a beginning of life (BoL) of the at least one cell (110), and
the controller (124) is configured to:

calculate negative electrode health for the at least one cell (110) based on the first charge data and the second charge data;
calculate reference negative electrode health associated with the BoL of the at least one cell (110) based on the third charge data; and
estimate the negative electrode safety based on the negative electrode health and the reference negative electrode health.

15. The battery system as claimed in claim 13, wherein the controller (124) is further configured to adjust a charge rate upper limit of the at least one cell (110) based on the estimated negative electrode safety.

FIG. 1

CONTROLLER /200

CHARGE DATA RECEIVER /210

NEGATIVE ELECTRODE HEALTH CALCULATOR /220

REFERENCE NEGATIVE ELECTRODE HEALTH CALCULATOR /230

NEGATIVE ELECTRODE SAFETY ESTIMATOR /240

CHARGE RATE ADJUSTER /250

FIG. 2

FIG. 3

FIG. 4

FIG. 5

FIG. 6

FIG. 7

FIG. 8

FIG. 9

S1000

START

RECEIVE FIRST CHARGE DATA FOR AT LEAST
ONE CELL FROM VOLTAGE SENSOR ⌐S1010

RECEIVE SECOND CHARGE DATA FOR AT LEAST
ONE CELL FROM VOLTAGE SENSOR ⌐S1020

RECEIVE THIRD CHARGE DATA ASSOCIATED
WITH BOL OF AT LEAST ONE CELL ⌐S1030

ESTIMATE NEGATIVE ELECTRODE SAFETY FOR AT LEAST
ONE CELL BASED ON FIRST, SECOND, AND THIRD CHARGE DATA ⌐S1040

ADJUST CHARGE RATE UPPER LIMIT OF AT LEAST ONE CELL
BASED ON ESTIMATED NEGATIVE ELECTRODE SAFETY ⌐S1050

END

FIG. 10

S1040

```
┌─────────┐
│  START  │
└────┬────┘
     │
     ▼                                              ╭─S1110
┌──────────────────────────────────────────────────────┐
│        CALCULATE DIFFERENTIAL VOLTAGE DATA             │
│        BASED ON CHARGING VOLTAGE DATA                  │
└────┬─────────────────────────────────────────────────┘
     │
     ▼                                              ╭─S1120
┌──────────────────────────────────────────────────────┐
│      CALCULATE PEAK CHARGE CAPACITY INCLUDED           │
│         IN DIFFERENTIAL VOLTAGE DATA                   │
└────┬─────────────────────────────────────────────────┘
     │
     ▼                                              ╭─S1130
┌──────────────────────────────────────────────────────┐
│  CALCULATE NEGATIVE ELECTRODE HEALTH FOR AT LEAST ONE  │
│  CELL BASED ON FIRST CHARGE DATA AND SECOND CHARGE DATA│
└────┬─────────────────────────────────────────────────┘
     │
     ▼                                              ╭─S1140
┌──────────────────────────────────────────────────────┐
│ CALCULATE REFERENCE NEGATIVE ELECTRODE HEALTH          │
│ ASSOCIATED WITH BOL OF AT LEAST ONE CELL BASED ON      │
│ THIRD CHARGE DATA                                      │
└────┬─────────────────────────────────────────────────┘
     │
     ▼                                              ╭─S1150
┌──────────────────────────────────────────────────────┐
│ ESTIMATE NEGATIVE ELECTRODE SAFETY BASED ON NEGATIVE   │
│ ELECTRODE HEALTH AND REFERENCE NEGATIVE ELECTRODE      │
│ HEALTH                                                 │
└────┬─────────────────────────────────────────────────┘
     │
     ▼
┌─────────┐
│   END   │
└─────────┘
```

FIG. 11

Europäisches
Patentamt

European
Patent Office

Office européen
des brevets

**EUROPEAN SEARCH REPORT**

**Application Number**

EP 25 16 1443

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 116 525 982 A (NINGDE CONTEMPORARY AMPEREX TECH CO LTD) 1 August 2023 (2023-08-01) | 1-4, 13-15 | INV. G01R31/367 G01R31/374 |
| Y | * the whole document * | 5-12 | G01R31/378 G01R31/3835 |
| Y | US 2021/359347 A1 (STEFANOPOULOU ANNA G [US] ET AL) 18 November 2021 (2021-11-18) * abstract * * paragraph [0047] - paragraph [0103]; figures 1-12 * | 5-7 | G01R31/388 G01R31/392 G01R31/396 H01M10/48 |
| Y | US 2023/160970 A1 (CHOI SOON-JU [KR] ET AL) 25 May 2023 (2023-05-25) * abstract * * paragraph [0048] - paragraph [0213]; figures 1-16 * | 8-10 | |
| Y | US 10 511 050 B1 (RAHIMIAN SAEED KHALEGHI [US] ET AL) 17 December 2019 (2019-12-17) * abstract * * column 3, line 34 - column 9, line 22; figures 1-6 * | 11,12 | TECHNICAL FIELDS SEARCHED (IPC) G01R |
| X | EP 4 184 188 A1 (HUAWEI TECH CO LTD [CN]) 24 May 2023 (2023-05-24) * abstract * * paragraph [0121] - paragraph [0165]; figures 4-7 * | 1-4 | H01M |
| X | WO 2023/148506 A1 (BREATHE BATTERY TECH LIMITED [GB]) 10 August 2023 (2023-08-10) * abstract * * page 8, line 17 - page 40, line 16; figures 1-16 * | 1-4 | |

-/--

The present search report has been drawn up for all claims

| Place of search | Date of completion of the search | Examiner |
|---|---|---|
| Munich | 21 August 2025 | Bergado Colina, J |

EPO FORM 1503 03.82 (P04C01)

**page 1 of 3**

Europäisches
Patentamt

European
Patent Office

Office européen
des brevets

**EUROPEAN SEARCH REPORT**

**Application Number**

EP 25 16 1443

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/231308 A1 (CHIANG YET-MING [US] ET AL) 13 September 2012 (2012-09-13)<br>* abstract *<br>* paragraph [0124] - paragraph [0126]; figures 1-6 * | 1-4 | |
| X | US 2020/379048 A1 (HUANG YU-HSIN [US] ET AL) 3 December 2020 (2020-12-03)<br>* abstract *<br>* paragraph [0027] - paragraph [0028]; figure 4 *<br>* paragraph [0034] - paragraph [0037]; figures 8-9 * | 1-4 | |
| X | US 2022/276314 A1 (KIM JI-YEON [KR] ET AL) 1 September 2022 (2022-09-01)<br>* abstract *<br>* paragraph [0053] - paragraph [0212]; figures 1-9 * | 1-4 | |
| A | CN 117 970 147 A (CHINA AUTOMOTIVE BATTERY RES INST CO LTD) 3 May 2024 (2024-05-03)<br>* the whole document * | 1-15 | TECHNICAL FIELDS SEARCHED (IPC) |
| A | WO 2023/121538 A1 (SCANIA CV AB [SE]) 29 June 2023 (2023-06-29)<br>* abstract *<br>* page 13, line 33 - page 20, line 27; figures 1-8 * | 1-15 | |
| A | US 2022/299577 A1 (KONISHI SHUNSUKE [JP] ET AL) 22 September 2022 (2022-09-22)<br>* abstract *<br>* paragraph [0021] - paragraph [0085]; figures 1-9 * | 1-15 | |

-/--

The present search report has been drawn up for all claims

| Place of search | Date of completion of the search | Examiner |
|---|---|---|
| Munich | 21 August 2025 | Bergado Colina, J |

EPO FORM 1503 03.82 (P04C01)

page 2 of 3

Europäisches
Patentamt

European
Patent Office

Office européen
des brevets

# EUROPEAN SEARCH REPORT

**Application Number**

EP 25 16 1443

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2015/147614 A1 (WANG SHUOQIN [US] ET AL) 28 May 2015 (2015-05-28) <br> * the whole document * <br> ----- | 1-15 | |
| A | EP 4 119 962 A1 (LG ENERGY SOLUTION LTD [KR]) 18 January 2023 (2023-01-18) <br> * abstract * <br> * paragraph [0033] - paragraph [0154]; figures 1-13 * <br> ----- | 1-15 | |
| A | US 2023/314515 A1 (BAE YOON-JUNG [KR] ET AL) 5 October 2023 (2023-10-05) <br> * abstract * <br> * paragraph [0045] - paragraph [0132]; figures 1-7 * <br> ----- | 1-15 | |
| A | US 2023/333174 A1 (CHOI HYUN-JUN [KR] ET AL) 19 October 2023 (2023-10-19) <br> * abstract * <br> * paragraph [0052] - paragraph [0187]; figures 1-12 * <br> ----- | 1-15 | **TECHNICAL FIELDS SEARCHED (IPC)** |

The present search report has been drawn up for all claims

| Place of search | Date of completion of the search | Examiner |
|---|---|---|
| Munich | 21 August 2025 | Bergado Colina, J |

EPO FORM 1503 03.82 (P04C01)

EP 4 653 891 A1

## ANNEX TO THE EUROPEAN SEARCH REPORT
## ON EUROPEAN PATENT APPLICATION NO.

EP 25 16 1443

This annex lists the patent family members relating to the patent documents cited in the above-mentioned European search report.
The members are as contained in the European Patent Office EDP file on
The European Patent Office is in no way liable for these particulars which are merely given for the purpose of information.

21-08-2025

| Patent document cited in search report | | Publication date | Patent family member(s) | | Publication date |
|---|---|---|---|---|---|
| CN 116525982 | A | 01-08-2023 | CN 116525982 A | | 01-08-2023 |
| | | | WO 2024222091 A1 | | 31-10-2024 |
| US 2021359347 | A1 | 18-11-2021 | CN 113272667 A | | 17-08-2021 |
| | | | EP 3833993 A1 | | 16-06-2021 |
| | | | KR 20210040423 A | | 13-04-2021 |
| | | | US 2021359347 A1 | | 18-11-2021 |
| | | | WO 2020033343 A1 | | 13-02-2020 |
| US 2023160970 | A1 | 25-05-2023 | CN 115398256 A | | 25-11-2022 |
| | | | EP 4119963 A1 | | 18-01-2023 |
| | | | JP 7395808 B2 | | 12-12-2023 |
| | | | JP 2023515831 A | | 14-04-2023 |
| | | | KR 20220094042 A | | 05-07-2022 |
| | | | US 2023160970 A1 | | 25-05-2023 |
| | | | US 2024402259 A1 | | 05-12-2024 |
| | | | WO 2022145777 A1 | | 07-07-2022 |
| US 10511050 | B1 | 17-12-2019 | CN 110658464 A | | 07-01-2020 |
| | | | US 10511050 B1 | | 17-12-2019 |
| EP 4184188 | A1 | 24-05-2023 | CN 112703125 A | | 23-04-2021 |
| | | | EP 4184188 A1 | | 24-05-2023 |
| | | | WO 2022032460 A1 | | 17-02-2022 |
| WO 2023148506 | A1 | 10-08-2023 | CN 119013573 A | | 22-11-2024 |
| | | | EP 4476554 A1 | | 18-12-2024 |
| | | | GB 2615355 A | | 09-08-2023 |
| | | | US 2025158437 A1 | | 15-05-2025 |
| | | | WO 2023148506 A1 | | 10-08-2023 |
| US 2012231308 | A1 | 13-09-2012 | CN 102037601 A | | 27-04-2011 |
| | | | EP 2171791 A2 | | 07-04-2010 |
| | | | JP 5558349 B2 | | 23-07-2014 |
| | | | JP 2011517361 A | | 02-06-2011 |
| | | | KR 20100057605 A | | 31-05-2010 |
| | | | TW 200915640 A | | 01-04-2009 |
| | | | US 2009123813 A1 | | 14-05-2009 |
| | | | US 2012231308 A1 | | 13-09-2012 |
| | | | WO 2009009758 A2 | | 15-01-2009 |
| US 2020379048 | A1 | 03-12-2020 | NONE | | |
| US 2022276314 | A1 | 01-09-2022 | CN 114270202 A | | 01-04-2022 |
| | | | EP 4012427 A1 | | 15-06-2022 |
| | | | ES 2994208 T3 | | 20-01-2025 |

For more details about this annex : see Official Journal of the European Patent Office, No. 12/82

EPO FORM P0459

page 1 of 3

30

## ANNEX TO THE EUROPEAN SEARCH REPORT
## ON EUROPEAN PATENT APPLICATION NO.

EP 25 16 1443

This annex lists the patent family members relating to the patent documents cited in the above-mentioned European search report.
The members are as contained in the European Patent Office EDP file on
The European Patent Office is in no way liable for these particulars which are merely given for the purpose of information.

21-08-2025

| Patent document cited in search report | | | Publication date | Patent family member(s) | | | Publication date |
|---|---|---|---|---|---|---|---|
| | | | | HU | E068013 | T2 | 28-12-2024 |
| | | | | JP | 7279294 | B2 | 23-05-2023 |
| | | | | JP | 2022539744 | A | 13-09-2022 |
| | | | | KR | 20210031226 | A | 19-03-2021 |
| | | | | PL | 4012427 | T3 | 23-09-2024 |
| | | | | US | 2022276314 | A1 | 01-09-2022 |
| | | | | WO | 2021049882 | A1 | 18-03-2021 |
| CN | 117970147 | A | 03-05-2024 | NONE | | | |
| WO | 2023121538 | A1 | 29-06-2023 | CN | 118401850 | A | 26-07-2024 |
| | | | | EP | 4453589 | A1 | 30-10-2024 |
| | | | | SE | 2151573 | A1 | 22-06-2023 |
| | | | | US | 2025044368 | A1 | 06-02-2025 |
| | | | | WO | 2023121538 | A1 | 29-06-2023 |
| US | 2022299577 | A1 | 22-09-2022 | CN | 115113079 | A | 27-09-2022 |
| | | | | JP | 7235790 | B2 | 08-03-2023 |
| | | | | JP | 2022144006 | A | 03-10-2022 |
| | | | | US | 2022299577 | A1 | 22-09-2022 |
| US | 2015147614 | A1 | 28-05-2015 | CN | 105705958 | A | 22-06-2016 |
| | | | | EP | 3071983 | A1 | 28-09-2016 |
| | | | | EP | 3792645 | A1 | 17-03-2021 |
| | | | | US | 2015147614 | A1 | 28-05-2015 |
| | | | | WO | 2015077669 | A1 | 28-05-2015 |
| EP | 4119962 | A1 | 18-01-2023 | CN | 115380221 | A | 22-11-2022 |
| | | | | EP | 4119962 | A1 | 18-01-2023 |
| | | | | EP | 4531164 | A2 | 02-04-2025 |
| | | | | ES | 3027835 | T3 | 17-06-2025 |
| | | | | HU | E071045 | T2 | 28-07-2025 |
| | | | | JP | 7395809 | B2 | 12-12-2023 |
| | | | | JP | 2023515838 | A | 14-04-2023 |
| | | | | KR | 20220093840 | A | 05-07-2022 |
| | | | | KR | 20250110780 | A | 21-07-2025 |
| | | | | PL | 4119962 | T3 | 19-05-2025 |
| | | | | US | 2023236262 | A1 | 27-07-2023 |
| | | | | US | 2024377472 | A1 | 14-11-2024 |
| | | | | WO | 2022145776 | A1 | 07-07-2022 |
| US | 2023314515 | A1 | 05-10-2023 | CN | 115516326 | A | 23-12-2022 |
| | | | | EP | 4145158 | A1 | 08-03-2023 |
| | | | | ES | 3027161 | T3 | 12-06-2025 |
| | | | | HU | E070700 | T2 | 28-06-2025 |
| | | | | JP | 7452780 | B2 | 19-03-2024 |

EPO FORM P0459

For more details about this annex : see Official Journal of the European Patent Office, No. 12/82

page 2 of 3

## ANNEX TO THE EUROPEAN SEARCH REPORT
## ON EUROPEAN PATENT APPLICATION NO.

EP 25 16 1443

This annex lists the patent family members relating to the patent documents cited in the above-mentioned European search report.
The members are as contained in the European Patent Office EDP file on
The European Patent Office is in no way liable for these particulars which are merely given for the purpose of information.

21-08-2025

| Patent document cited in search report | Publication date | Patent family member(s) | | Publication date |
|---|---|---|---|---|
| | | JP | 2023527335 A | 28-06-2023 |
| | | KR | 20220080620 A | 14-06-2022 |
| | | PL | 4145158 T3 | 09-06-2025 |
| | | US | 2023314515 A1 | 05-10-2023 |
| | | WO | 2022124773 A1 | 16-06-2022 |
| US 2023333174 A1 | 19-10-2023 | CN | 114270204 A | 01-04-2022 |
| | | EP | 4063883 A1 | 28-09-2022 |
| | | ES | 3001883 T3 | 06-03-2025 |
| | | HU | E069417 T2 | 28-03-2025 |
| | | JP | 7331326 B2 | 23-08-2023 |
| | | JP | 2022544981 A | 24-10-2022 |
| | | KR | 20210150217 A | 10-12-2021 |
| | | PL | 4063883 T3 | 03-02-2025 |
| | | US | 2023333174 A1 | 19-10-2023 |
| | | WO | 2021246655 A1 | 09-12-2021 |

EPO FORM P0459

For more details about this annex : see Official Journal of the European Patent Office, No. 12/82

page 3 of 3